**Europäisches Patentamt**

**European Patent Office**

**Office européen des brevets**

(19)

(11) Publication number : **0 469 973 A1**

## (12) EUROPEAN PATENT APPLICATION

(21) Application number : **91402086.2**

(51) Int. Cl.[5] : **G03F 7/095,** G03F 7/16

(22) Date of filing : **25.07.91**

(30) Priority : **27.07.90 JP 197825/90**

(43) Date of publication of application :
**05.02.92 Bulletin 92/06**

(84) Designated Contracting States :
**DE FR GB IT**

(71) Applicant : **MITSUBISHI RAYON CO., LTD
3-19, Kyobashi 2-chome Chuo-ku
Tokyo (JP)**

(72) Inventor : **Kushi, Kenji, c/o CENTRAL
RESEARCH LABORATORIES
MITSUBISHI RAYON CO. LTD., 20-1,
Miyuki-cho
Otake-shi, Hiroshima-ken (JP)**
Inventor : **Inukai, Ken-ichi, c/o CENTRAL
RESEARCH LAB.
MITSUBISHI RAYON CO. LTD., 20-1,
Miyuki-cho
Otake-shi, Hiroshima-ken (JP)**

(74) Representative : **Fort, Jacques
CABINET PLASSERAUD 84, rue d'Amsterdam
F-75009 Paris (FR)**

(54) **Method for forming relief patterns.**

(57) A method for forming relief patterns which is particularly applicable to forming solder resist patterns during the fabrication of printed circuit boards is disclosed. The disclosed method entails the steps of forming an alkali developable photosensitive layer by applying a solvent-free liquid type photosensitive resin composition over a substrate, the solvent-free liquid type photosensitive resin composition having an acid value A and a viscosity B (cps) measured at 23° C using a Brookfield viscosity meter, such that the relationship $300A + 200 > B$ is satisfied ; forming a laminate by applying an alkali developing dry film resist layer over the alkali developable photosensitive layer ; selectively exposing the intermediate alkali developing photosensitive layer and alkali developable dry film resist layer with light ; and removing the portions of the intermediate alkali developable photosensitive layer and alkali developing dry film resist layer which were not exposed to light in the preceding step by means of an alkali developing solution. The disclosed method makes it possible to efficiently and economically create complex relief patterns which remain adherent to the substrate despite exposure to high temperatures during soldering, remain adherent over a long life time, and show excellent resistance to solvents and other chemical agents.

**EP 0 469 973 A1**

## Background of the Invention

### [Field of the Invention]

The present invention relates to methods used to form relief patterns over uneven surfaces, and more particularly, to methods for forming relief patterns employing liquid type photopolymerizable resin compositions together with dry resist film as, for example, in the fabrication of printed circuit boards.

### [Prior Art]

Conventionally, in fields involved with the fabrication of printed circuit boards, solder resist has been broadly employed as a long lasting protective layer therefor. In these applications, the solder resist layer serves a number of different functions. First of all, during circuit assembly, the solder resist layer helps to prevent the formation of unwanted solder bridges between closely juxtaposed conductive regions on the printed circuit board as components are mounted thereon by soldering. Subsequently, during the useful service life of the printed circuit board, the solder resist layer acts to protect conductive regions on the board from corrosion, and to maintain the electrically insulating characteristics of regions which are intended to be nonconducting.

Solder resist differs from etching resist and plating resist which are used under different circumstances and conditions. Solder resist is used to form a relief pattern over the upper surface of a substrate. With solder resist, it is essential that a pattern formed therefrom adhere tightly, uniformly and without defects, to the underlying substrate, especially so with extremely complex and convoluted patterns.

In order for the solder resist layer to perform its intended functions, and to continue to do so over an extended lifetime, even when exposed to extremely harsh conditions, the material from which the resist layer is formed must meet the following requirements:

a) the material must be able to maintain its adhesive properties following exposure to the high temperatures (240 - 280° C) which develop during soldering;

b) the adhesive properties thereof must endure over an extended service life;

c) the resist material must be able to withstand exposure to solvents and other chemical substances without deterioration of the physical properties thereof; and

d) the material must be able to maintain electrically insulating characteristics even at high ambient humidity. To meet the above demands, thermally polymerizable ink, photo-polymerizable ink and related substances have been used in the past, typically applied using a silk screen printing method to form a solder resist mask.

In recent years, however, advances in component miniaturization have made much higher component density possible and advances in integrated circuit packaging techniques have permitted manufacture of individual integrated circuits having one hundred or more leads. As a direct consequence, the demands placed on printed circuit board fabrication technology in terms of the capability to support increasingly complex and dense (i.e. high number of conducting pathways for a given surface area) resist patterns has expanded dramatically. Although this need has been partially answered through the development of multilayer printed circuit boards, it has been found that in general, production of boards having more than seven or eight layers becomes impractical.

In the case of multilayer printed circuit boards and boards with a resist pattern on both sides thereof, when the resist pattern for each layer is highly complex, tension applied to the silk screen mesh and positioning thereof during resist pattern formation becomes highly critical and must be carefully controlled in order to avoid malpositioning of the individual layers with respect to one another. Additionally, smudging and spilling of minute drops of the polymerizable ink can easily result in short circuits or other defects in one or more layers of the printed circuit boards that are produced.

The overall result of the above described advances in electronic components technology is that conventional techniques for forming resist patterns has been pushed to its farthest limits. As a consequence, when conventional methods for forming solder resist patterns are used for extremely complex circuits, the resulting solder resist layers are much too thin in order to meet the above described requirements for the solder resist layer, that is, to maintain adhesive properties over a long period of time, even during and following exposure to high temperatures, to be able to resist damage from chemical agents and mechanical schock, and to maintain high electrical insulating properties even at high ambient humidity.

In response to the shortcomings of conventional media, in recent years, attempts have been made to develop methods using photoresist techniques in place of silk screening methods. In one such method, a photo-sensitive resin layer is formed over a substrate layer which is then selectively exposed to light of an appropriate wavelength, whereby the exposed regions come to be hardened. The portions not exposed to light, and thus not hardened, can then be removed using a developing process. As a result, an exceedingly complex pattern can be accurately reproduced in the form of solder resist.

Because the solder resist is formed on the elevated or depressed portions of the surface of a substrate, that is, over the conducting bands of copper foil and non-conducting areas which have been formed thereon, it is important that the solder resist have excellent adhesion properties so as to tightly adhere to this kind of uneven surface.

Many different approaches have been suggested for forming the photo-sensitive layer used for solder resist and photoresist techniques so as to meet the demanding requirements therefor. Unfortunately, none of the conventional technology is entirely satisfactory.

For example, in Japanese Patent Application, First Publication Serial No. Sho-51-15733, a photosensitive resin composition is dissolved in a suitable organic solvent, after which the solution thus prepared is applied over a substrate. Subsequently, the organic solvent is volatilized through application of heat, and thus driven away, leaving a photosensitive resin layer overlying the substrate. It has been found difficult, however, to reliably form resist patterns having sufficient thickness using this method. Additionally, it is difficult to tent over the small diameter throughholes in the circuit board.

In the case of the dry film resist method recited in Japanese Patent Application, First Publication Serial No. Sho-54-1018, the problems relating to sufficient thickness of the resist pattern and problems relating to tenting do not occur. Unfortunately, as is also the case with the method recited in Japanese Patent Application, First Publication Serial No. Sho-52-52703, in order to provide sufficient adherence to the elevated portions and recessed portions of the substrate, an additional step involving application of heat and pressure under low atmospheric pressure is required. Even with the additional step, the adhesiveness of the resist pattern to the substrate tends to be inadequate with these methods.

In the case of methods using dry film resist, various means have been proposed for enhancing the adhesive properties of the resist pattern to the elevated portions and recessed protions of the substrate formed thereby, such as in Japanese Patent Application, First Publication Serial No. Sho-63-74051, wherein a step using a non-light sensitive liquid is used so as to form an intermediate layer. However, with these methods, after the photo-sensitive layer is subsequently applied, the laminate thereby formed must be cured after an extended period of time in order to harden the intermediate layer, before the steps of photoexposure and development to form the resist pattern are carried out. Consequently, manufacturing time is increased considerably, which proves to be a significant problem.

## Summary of the Invention

In consideration of the above described shortcomings of the conventional technology, it is an object of the present invention to provide an improved method for forming relief patterns over uneven surfaces, applicable to solder resist and the like, which does not entail a great number of manufacturing processes, and which avoids time consuming and overly complicated steps, whereby a complex relief pattern having adequate thickness and adhesive properties can be simply an precisely reproduced in a short period of time.

As a result of extensive research, the present inventors have found that the above described object of the present invention can be effectively achieved through preparing an intermediate alkali developable photosensitive layer formed from a solvent-free liquid type photosensitive resin composition having particular physical properties and forming an alkali developable dry film resist layer thereover. Accordingly, the present invention provides a method for forming relief patterns including the steps of:

a) forming an intermediate alkali developable photosensitive layer by applying a solvent-free liquid type photosensitive resin composition over a substrate, the solvent-free liquid type photosensitive resin composition having an acid value A and a viscosity B (cps) measured at 23° C using a Brookfield viscosity meter, such that the following Equ. 1:

$$300A \ + \ 200 > B \quad Equ. \quad 1$$

is satisfied;

b) forming a laminate by applying an alkali developable dry film resist layer over the intermediate alkali developable photosensitive layer;

c) selectively exposing the intermediate alkali developable photosensitive layer and alkali developable dry film resist layer with light; and

d) removing the portions of the intermediate alkali developable photosensitive layer and alkali developable dry film resist layer which were not exposed to light in the preceding step by means of an alkali developable solution.

The above described method of the present invention can be suitably employed to form a relief pattern over a substrate surface which itself has a relief pattern consisting of projecting and recessed portions. Although this method can be used to apply a relief pattern over many different types of substrates and for various uses, the method of the present invention is particularly useful in the manufacture of printed circuit boards where it can be used for forming a solder resist pattern over a substrate consisting of a conducting relief pattern formed over an electrically insulating substrate material.

Through use of the method of the present invention, the laminate formed from the intermediate alkali developable photosensitive layer and alkali developable dry film resist layer can be rapidly and easily prepared, and furthermore, light exposure and development can be carried out soon thereafter, whereby exceedingly complex relief patterns can be precisely, reliably and efficiently reproduced. The relief patterns thereby fabricated have excellent and enduring adhesion to the underlying substrate, and the thickness thereof can be readily adjusted to suit requirements of the application. Moreover, relief patterns formed by the method of the present invention demonstrate excellent ability to withstand the temperatures generated during soldering of electronic components, as well as to resist deterioration induced by exposure to solvents, other chemical agents or mechanical schock.

Accordingly, the method of the present invention provides an exceedingly useful method for forming solder resist patterns over printed circuits, whereby efficient and economical production of extremely high quality printed circuit boards can be achieved, including those with a highly complex circuit layout.

Detailed Description of the Preferred Embodiments

In the following, a preferred embodiment of the present invention will be described. Experimentally determined values comparing the characteristics of printed circuit boards with solder resist patterns fabricated using method of the present invention and those with solder resist patterns fabricated using conventional methods will be presented.

For the underlying electrically insulating substrate, both flexible materials and those which are not flexible are acceptable. Examples of flexible materials include those used in conventional flexible printed circuit boards such as polyethylene terephthalates and polyimides with an adhesive layer optionally applied thereover. Examples of rigid materials include those used in conventional rigid printed circuit boards such as phenol laminated paper, glass epoxy laminates, thermoplastics, thermosetting resins, ceramics and others.

For the conductive substrate relief pattern formed over the electrically insulating substrate, examples of suitable materials therefor include those used in conventional printed circuit boards such as copper foil and solder. In addition, metals such as gold, iron, silver and palladium, alloys thereof, carbon paste, and various types of organic conducting materials can be used in place of or in addition to copper foil, solder and the like.

It has been found that if the underlying relief pattern has indentations with a depth ranging from at least 2 μm, or more preferably from at least 4 μm, up to a depth of 300 μm, application of solder resist thereover by the method of the present invention provides superior results compared with when conventional methods are employed.

In the first step of the method of the present invention, the intermediate alkali developable photosensitive layer is formed over the substrate, typically over one of the above described conductive substrate relief patterns and the electrically insulating substrate, by applying a solvent-free liquid type photosensitive resin composition over the substrate. This solvent-free liquid type photosensitive resin composition should have an acid value A and a viscosity B (cps) measured at 23° C using a Brookfield viscosity meter, such that Equ. 1:

$$300A + 200 > B \quad \text{Equ. 1}$$

is satisfied, where B is stated in terms of cps units. Provided that the solvent-free liquid type photosensitive resin composition is constituted such that the above Equ. 1 is satisfied, and so that it is in the liquid state at ordinary temperatures, and so that it can be hardened by exposure to light of a suitable wavelength, and unexposed portions can be removed using an alkali developing solution, various photopolymerizing resin compositions can be used therefor.

By choosing the solvent-free liquid type photosensitive resin composition so that Equ. 1 is satisfied, improved tight-contact to the substrate is achieved, and moreover, the ability to precisely and easily remove non-light exposed portions thereof with alkali developer is enhanced. This point will be elaborated upon in a following section.

To improve handling characteristics of the solvent-free liquid type photosensitive resin composition during application thereof, the viscosity B as measured at 23° C using a Brookfield viscosity meter should ideally be 10,000 cps or less. For the acid value A thereof, a value of zero is perfectly acceptable, in which case viscosity B must be less than 200 cps in accordance with Equ. 1 describing the requisite characteristics of the solvent-free liquid type photosensitive resin composition. Resin compositions having a high acid value are also acceptable.

In consideration of affenity of the alkali developable dry film resist layer in the intermediate alkali developable photosensitive layer over which it is applied, ideally the solvent-free liquid type photosensitive resin composition used for the intermediate alkali developable photosensitive layer should have at least one type of polymerizable carbon-carbon double bond possessing chemical compound as a principle constituent thereof, and moreover, should include a photopolymerization initiator or a photosensitizing agent.

Examples of suitable polymerizable carbon-carbon double bond possessing chemical compounds for the solvent-free liquid type photosensitive resin composition of the present invention include various conventionally known materials composed of (meth)acrylates and (meth)acryl amides. Representative examples thereof include monofunctional organic compounds such as phenoxyethyl (meth)acrylate and butoxymethyl (meth)acryl amide; bifunctional organic compounds such as ethylene glycol di(meth)acrylate, tetraethylene glycol di(meth)acrylate, tetrapropylene glycol di(meth)acrylate, hexapropylene glycol di(meth)acrylate, neopentyl glycol di(meth)acrylate, (meth)acryloyloxypivalyl (meth)acryloyloxypivalate, and 2,2-bis-((meth)acryloyloxy ethoxypheny)propane; trifunctional organic compounds such as trimethylol propane tri(meth)acrylate, tris-[(meth)acryloyloxyethoxymethyl]propane and pentaerythritol tri(meth)acrylate; epoxy (meth)acrylate compounds such as 2,2-bis-((3-(meth)acryloyloxy-2-hydroxy)propoxyphenyl) propane; urethane (meth)acrylate compounds; oligoester (meth)acrylate compounds and others.

With polymerizable chemical compounds which are difficult to develop in alkali developing solution, such compounds are preferably used in combination with one or more other polymerizable carbon-carbon double bond possessing compounds which additionally possess one or more carboxyl groups, in this way enhancing the ease of development of the solvent-free liquid type photosensitive resin composition. Representative examples of this type of compound include mono(meth)acryloyloxyethylphthalate, mono(meth)acryloyloxyethylsuccinate, bisphenol A diglycidyl ether/acrylic acid/maleic anhydride condensate, Aronix TR M-5300 and Aronix TR M-5600 (Toa Synthetic Chemical Industries, Inc.), and methylenebis(4-cyclohexylisocyanate)/hydroxypropylacrylate/glycerin/ maleic anhydride 1:1:1:1 condensation product, among others. The viscosity of the photopolymerizable resin composition can be controlled by selecting the combination of the above listed compounds.

Various types of conventionally known photopolymerization initiators can be used, representative examples of which include benzophenone, 4,4'-bis(diethylamino)benzophenone, Michler's ketone, t-butyl anthraquinone, 2-ethyl anthraquinone, thioxanthone compounds, benzoin alkyl ethers, benzil ketals and others, alone or in combination.

Application of the solvent-free liquid type photopolymerizable resin composition over the substrate can be accomplished using many conventionally known techniques, including silk screen printing, dipping, using a roll coater, roller brush, blade coater, rod coater, curtain coater, electrostatic application, spraying and various other methods. When a relief pattern is to be formed over both sides of a substrate and the solvent-free liquid type photopolymerizable resin composition to be used has a Brookfield viscosity of 500 cps or less at 23° C, the best results will generally be obtained by dipping the substrate in the solvent-free liquid type photopolymerizable resin composition.

The thickness of the photosensitive intermediate layer which is to be formed is not particularly limited. Generally, however, a thickness of on the order of 0.1 to 30 $\mu$m tends to produce the best results.

After the solvent-free liquid type photopolymerizable resin composition is applied over the substrate thereby forming the photosensitive intermediate layer, step b of the method of the present invention is carried out, wherein an alkali developable dry film resist layer is formed. Although many conventionally known dry film resist materials can be used for this layer, when a solder resist relief pattern is to be formed, it has been found desirable to use a composition which consists of:

a) 30 to 70 weight % of acrylic polymer(s) having carboxyl groups;

b) 30 to 70 weight % of organic compound(s) with a boiling point of 100° C or greater and with intramolecular carbon-carbon double bonds; and

c) 0.01 to 15 weight % of photopolymerization initiator. For component a above, for example tertiary copolymers such as MMA/MA/MAA, MMA/EA/MAA, MMA/BA/MAA, MMA/2EHA/MAA, and quaternary copolymers such as MMA/St/MA/MAA, MMA/St/EA/MAA, MMA/St/BA/MAA and MMA/St/2EHA/MAA.

In order to achieve an optimal balance between the electrical insulating characteristics of solder resist and the ease of removing nonhardened (non-light exposed) portions thereof with alkali developing solution, it has generally been found desirable that the overall acid value of the dry film resist be in the range of 20 to 100. An acid value in this range achieved by adjusting the amount and type of carboxyl group possessing acrylic polymer used in component a of the dry film resist.

The organic compound(s) with a boiling point of 100° C or greater and with intramolecular carbon-carbon double bonds used in component b above can be selected from many conventionally known compounds, although in consideration of solubility in component a and hardening characteristics, it is generally preferable that the principal components thereof consist of organic compounds having (meth)acryloxy groups, for example, monofunctional compounds such as phenoxyethyl(meth)acrylate and phenoxyethoxyethyl(meth)acrylate; bifunctional organic compounds such as polyethylene glycol di(meth)acrylate, polypropylene glycol di(meth)acrylate, neopentyl glycol di(meth)acrylate, (meth)acryloyloxypivalyl, (meth)acryloyloxypivalate, and 2,2-(bis(meth)acryloyloxyethoxyphenyl)propane; tri- or morefunctional organic compounds such as trimethylol propane tri(meth)acrylate, 1,1,1-tris((meth)acryloyloxyethoxymethyl)propane, pentaerythritol tri(meth)acrylate and dipentaerythritol penta(meth)acrylate; epoxy (meth)acrylate compounds such as bis-((3-(meth)acryloyloxy-2-hydroxy)propoxyphenyl) propane; urethane (meth)acrylate compounds; oligoester (meth)acrylate compounds and others. Although not particularly limited, it has found to be preferable if the average number of intramolecular carbon-carbon double bonds per molecule of component b is more than 1.2.

Various conventionally known photopolymerization initiators can be used as the photopolymerization initiator of component c, including those discussed previously in connection with the intermediate alkali developable photosensitive layer. Although different photopolymerization initiators may be used in the intermediate alkali developable photosensitive layer and the dry film resist layer, it is preferable to use the same agent in both layers.

As for the thickness of the dry film resist layer, in terms of protective characteristics, a thickness which is at least one half of distance between projections and recesses in the underlying relief pattern.

Lamination of the alkali developable dry film resist over the intermediate alkali developable photosensitive layer can be accomplished using many conventionally known techniques, including hot rolling at atmospheric pressure, hot rolling in a vacuum, hot pressing at atmospheric pressure, hot pressing in a vacuum and other methods. In general, hot rolling at atmospheric pressure tends to produce the best results in terms of uniform thickness and a smooth, defect free surface easily. An alternate method is to lay a supporting film or a supporting sheet on the surface of the alkali developable dry film resist opposite to the photosensitive intermediate layer.

The laminate of the intermediate alkali developable photosensitive layer and dry film resist layer as thus prepared is selectively exposed with light of an appropriate wavelength, thereby inducing photopolymerization and hence hardening of the exposed portions. Ultraviolet light or visible light can be used. To create a selectively exposed pattern, a photomask can be placed between the laminate and the light source. A direct imaging method with a laser light can also be used.

After the laminate has been selectively exposed to light, the non-exposed portions are then removed using alkali developing solution. By spraying with a suitable alkali developing solution, both chemical and physical removal of unhardened portions can be effected. Developing can also be achieved by a combination of dipping and spraying. Suitable developing solutions include aqueous sodium carbonate, aqueous sodium phosphate, aqueous potassium carbonate and various other alkaline aqueous solutions. If desired a surface activating agent and/or antifoaming agent can be added.

Provided the solvent-free liquid type photosensitive resin composition which forms the intermediate alkali developable photosensitive layer has a Brookfield viscosity of less than 200 cps, resin composition can generally be mechanically removed by spraying with developing solution. If the solvent-free liquid type photosensitive resin composition has a Brookfield viscosity of 200 cps or greater, there is a tendency for some of the undeveloped resin composition to remain following mechanically spraying with developing solution since chemical removal will be imcomplete. For that reason, a higher acid value for the solvent-free liquid type photosensitive resin composition is useful to enhance chemical removal by the developing solution. Thus, if the previously discussed Equ. 1 is satisfied, developing characteristics of the intermediate alkali developable photosensitive layer are enhanced by both improved chemical removal as well as mechanical removal achieved by spraying the developing solution. Conversely, if a photosensitive intermediate layer satisfying Equ. 1 is not used, improved adhesion to the elevated or depressed areas of the surface of the substrate and rapid and complete developing are not obtained.

In addition to the steps described above, an additional step can be added when necessary so as to further improve the results of resist pattern forming. For example, it sometimes happens that the light exposure step in (c) of the method of the present invention does not achieve complete photopolymerization, with the result that light exposed portions of the intermediate alkali developable photosensitive layer and dry film resist are only partially hardened. In such cases, an additional hardening step can be carried out, for example, a second photoexposure step following development. Also, a final heat treatment step can be carried out to relieve any residual stress in the hardened solvent-free liquid type photosensitive resin composition and dry film resist resulting from contraction thereof.

In the following, the steps involved with the actual preparation of relief patterns in accordance with the method of the present invention will be described.

Preparation of solvent-free liquid type photosensitive resin compositions:

First of all, six sample resin composition L1 through L6 were prepared by uniformly mixing the components listed in Table 1 in the stated proportions.

## TABLE 1

| | Parts by weight | | | | | |
|---|---|---|---|---|---|---|
| | L1 | L2 | L3 | L4 | L5 | L6 |
| bisphenol A diglycidyl ether/acrylic acid/maleic anhydride condensate[1] (acid value 40) | 36 | 22 | | 22 | 11 | |
| bisphenol A diglycidyl ether/acrylic acid condensate[2] (acid value 0) | | | | 30 | 25 | 30 |
| acryloyloxy pivalyl acryloyloxy pivalate | 27 | 34 | | 15 | 27 | 30 |
| tetrapropylene glycol diacrylate | | | 90 | | | |
| polybutadiene acrylate[3] | | | | 8 | | |
| phenoxyethyl acrylate | 27 | 34 | | 15 | 27 | 30 |
| benzildimethyl ketal | 9.9 | 9.9 | 9.9 | 9.9 | 9.9 | 9.9 |
| p-methoxy phenol | 0.1 | 0.1 | 0.1 | 0.1 | 0.1 | 0.1 |

1) reaction ratio for epoxy group of bisphenol A diglycidyl ether/ acrylic acid/maleic anhydride = 1/1/0.25

2) reaction ratio for epoxy group of bisphenol A diglycidyl ether/ acrylic acid = 1/1

3) Polybd ACR-LC  (a product of Idemitsu Sekiyu Inc.)

After sample resin compositions L1 through L6 were prepared as described above, the acid value and Brookfield viscosity at 23° C was determined for each sample, the results of which are shown in Table 2.

TABLE 2

|  | L1 | L2 | L3 | L4 | L5 | L6 |
|---|---|---|---|---|---|---|
| acid value A | 15 | 9 | 0 | 9 | 4 | 0 |
| 300A + 200 | 4700 | 2900 | 200 | 2900 | 1400 | 200 |
| Brookfield viscosity B cps | 4100 | 660 | 28 | 4700 | 2000 | 400 |

Preparation of alkali developable dry film resist material:

To a mixture of 45 parts by weight of isopropyl alcohol and 105 parts by weight of methylethyl ketone, 100 parts by weight of a copolymer consisting of methylmethacrylate/methylacrylate/methacrylic acid (65:15:20 by weight) was added while the solution was stirred until all of the copolymer dissolved. To this solution, 20 parts by weight of tris(acryloyloxyethoxymethyl)propane, 30 parts of tetrapropylene glycol diacrylate, 20 parts of trimethylolpropane triacrylate, 10 parts of benzildimethylketal, 0.5 parts of granular copper phthalocyanine green and 0.1 parts of p-methoxy phenol were added with stirring. The resin composition thus prepared was then applied over a 25 $\mu$m thick 360 mm wide polyester film strip and dried to produce a 50 $\mu$m thick resin layer. Subsequently, the sample was heated for 4 min. at 90° C in a convection oven. Finally, the sample was applied over 30 $\mu$m thick polyethylene film, thereby producing a sample of alkali developable dry film resist (DFR-1).

(Experimental Examples 1 to 3]

Circuit boards having a thickness of 1.6 mm with 0.35 and 0.9 mm diameter through holes and 50 $\mu$m thick copper layer on both sides were degreased with trichloroethane vapor and cleaned of oxidation products using 10% $H_2SO_4$. The circuit boards were then washed, dried, after which each board was gently immersed in a full container of one of the resin compositions L1 through L3 at a rate of 0.5 cm/sec while held vertically. When fully immersed, the boards were maintained in that state for 10 seconds, after which they were pulled out of the resin compositions at a rate of 1 cm/sec, thereby yielding circuit boards with an intermediate alkali developable photosensitive layer formed on each side thereof.

Next, using a DFR use ML480 laminater (MCK Corporation), the DFR-1 film prepared previously was peeled of the polyethylene film and laminated to each side of the intermediate layer of the circuit boards at a roll temperature of 100° C, cylinder air pressure of 2.5 kg/cm², and lamination speed of 2.0 m/min. Each laminated circuit board thus prepared was examined for air pockets, the results of which are shown in Table 3 below.

TABLE 3

|  | Experimental Example 1 | Experimental Example 2 | Experimental Example 3 |
|---|---|---|---|
|  | L1 | L2 | L3 |
| presence of air pockets | none | none | none |

Each surface of the prepared laminated boards was overlaid with a solder resist photo mask 15 min. after lamination step and exposed to illumination from an ultra high pressure mercury vapor lamp at 150 mJ/cm². Next, the photo masks and DFR-1 support films were peeled away, each surface thereof sprayed with aqueous solution of 1% sodium carbonate at 30° C for 2 minutes with a 1/8 FJJ XP030 full cone spray nozzle (K. Ikeuchi & Co.) at a distance of 14 cm, water pressure of 1.6 kg/cm², resulting in a water flow per unit area of 9 cc/cm²·min. in order to effect development. Finally, the boards were rinsed in water and dried.

With the boards thus prepared, adherence of hardened resin to the selectively exposed surface of the boards, the unexposed portions thereof and the through holes were examined using light microscopy and fluorescent microscopy. The results are listed in Table 4 below.

Using a high pressure mercury vapor lamp at 2 J/cm², the boards were again photoexposed, after which they were heat treated for 1 hour at 150° C to provide adequate hardness. Characteristics of the solder resist thus prepared were then assessed (ability to withstand soldering, adherence, resistance to solvents), the results of which are also shown in Table 4 below.

## TABLE 4

| | Expermnt. Example 1 L1 | Expermnt. Example 2 L2 | Expermnt. Example 3 L3 |
|---|---|---|---|
| Adherence of light exposed portions of solder resist to underlying substrate | very good | very good | very good |
| Developing characterists of solder resist in 1% sodium carbonate solution | very good | very good | very good |
| Resistance to soldering temperature (260° C for 20 sec) after heat treatment | no damage | no damage | no damage |
| Cross cut - tape stripping test[1] (removed surface area %) | < 10% | < 10% | < 10% |
| resistance to trichloroethane vapor (86.7 °C for 5 sec) | no damage | no damage | no damage |

1) surface of solder resist cut into 2 mm square checker board pattern, #610 tape (3M Corp.) applied over surface, after which tape is peeled off and % area of resist pulled off with tape is counted

[Comparative Example 1]

Using a circuit board identical to that used in Experimental Example 1, both sides thereof were degreased with trichloroethane vapor and cleaned of oxidation products using 10% $H_2SO_4$, washed, dried, after which the board was then laminated with DFR-1 as in Experimental Example 1 (100° C, air cylinder pressure 2.5 kg/cm² and 2 m/min) with no formation of a photosensitive intermediate layer. The laminated boards thus prepared were then examined, whereupon multiple air bubbles were seen beneath the DFR-1 film, adjacent to the edges of copper conductor. When lamination was repeated at 130° C, air cylinder pressure 3.5 kg/cm² and 0.2 m/min, the air bubbles continued to be present.

[Comparative Example 2]

Using a circuit board identical to that used in Experimental Example 1, both sides thereof were degreased with trichloroethane vapor and cleaned of oxidation products using 10% $H_2SO_4$, washed, dried, after which just as in Experimental Example 1, the board was immersed in tetrapropyleneglycol diacrylate which did not include a photo sensitizer in order to form a non-photosensitive intermediate layer. Lamination with DFR-1 film was then carried out just as in Experimental Example 1.

Each surface of the laminated board was then overlaid with a solder resist photo mask 15 min. after lamination and exposed in order to partially cure to illumination from an ultra high pressure mercury vapor lamp at 120 mJ/cm². Next, the photo masks and DFR-1 support films were peeled away, each surface thereof sprayed with 1% sodium carbonate at 30° C for 2 minutes. Finally, the board was rinsed in water and dried. Adherence of hardened resin to the surface of the board was examined using light microscopy, whereupon portions at which the DFR-1 film had peeled away from the substrate were seen. As a result, the intermediate layer which contains no photosensitizer was hardened little and the edges of the resist pattern were pealed off. Irradiation at 120 mJ/cm² provided essentially no improvement.

[Comparative Examples 3 to 5]

Using the sample resin compositions L4 through L6 prepared as described above, comparative circuit boards were prepared by a method identical to that of Experimental Example 1. With the boards thus prepared, the unexposed portions of the boards and the through holes were examined using light microscopy and fluorescent microscopy. The results are listed in Table 5.

TABLE 5

|  | Comparative Example 1 L4 | Comparative Example 2 L5 | Comparative Example 3 L6 |
|---|---|---|---|
| 2 minute development | poor results | poor results | poor results |
| 5 minute development | poor results | poor results | poor results |

[Experimental Examples 4 to 9]

The same procedure as in Experimental Example 1 is carried out, except that the solvent-free liquid type photosensitive resin compositions in Table 6 are used in place of resin composition L1. In this way, the same results as obtained in Example 1 can be achieved.

[Experimental Examples 10 and 11]

The same procedure as in Experimental Example 3 is carried out with circuit boards identical to those employed in Experimental Example 3, except that circuit boards for which the copper layer is 75 μm thick and circuit boards for which the copper layer is 38 μm thick are used. In this way, the same results as obtained in Example 3 can be achieved.

[Experimental Example 12]

The same procedure as in Experimental Example 3 is carried out with circuit boards identical to those employed in Experimental Example 3, except that laminates are prepared using DFR-1 film with a thickness of 75 μm. The laminates are then selectively exposed to 200 mJ/cm² and developed. In this way, the same results as obtained in Example 3 can be achieved.

[Experimental Example 13]

The same procedure as in Experimental Example 12 is carried out, except that copper layer thickness is 95 μm. In this way, the same results as obtained in Example 12 can be achieved.

[Experimental Example 14]

To a mixture of 45 parts by weight of isopropyl alcohol and 105 parts by weight of methylethyl ketone, 110 parts by weight of a copolymer consisting of methyl methacrylate/styrene/n-butyl acrylate/methacrylic acid (50:10:15:25 by weight) is added while the solution is stirred until all of the copolymer is dissolved. To this solution, 60 parts by weight of tris(acryloyloxyethoxymethyl)propane, 5 parts of tetraethylene glycol diacrylate, 5 parts of acryloyloxypivalyl acryloyloxypivalate, 10 parts of benzildimethylketal, 0.5 parts of copper phthalocyanine green powder, 0.5 parts of 5-amino-1H-tertrazole monohydrate and 0.1 parts of p-methoxy phenol are added with stirring. The resin composition prepared in this way is then applied over a 25 $\mu$m thick 360 mm wide polyester film strip and dried to produce a 50 $\mu$m thick resin layer. Subsequently, the sample was heated for 4 min. at 90° C in a convection oven. Finally, the sample is applied over 30 $\mu$m thick polyethylene film, the same procedure as in Example 4 is carried out except that this dry film resist is used and selectively exposed to 200 mJ/cm². In this way, the same results as obtained in Example 12 can be achieved.

## Claims

1. A method for forming relief patterns including the steps of:
   a) applying a solvent-free liquid type photosensitive resin composition over an uneven substrate so as to form an intermediate alkali developable photosensitive layer, the solvent-free liquid type photosensitive resin composition having an acid value A and a viscosity B (cps) measured at 23° C using a Brookfield viscosity meter, such that the following Equation:
$$300A + 200 > B$$
   is satisfied;
   b) forming a laminate by applying an alkali developable dry film resist layer over said intermediate alkali developable photosensitive layer;
   c) selectively exposing said laminate with light; and
   d) removing the portions of said laminate which were not exposed to light in the preceding step by means of an alkali developing solution.

2. A method for forming relief patterns in accordance with claim 1 above, wherein said alkali developable dry film resist layer is comprised of:
   a) 30 to 70 weight % of at least one acrylic polymer having carboxyl groups;
   b) 30 to 70 weight % of at least one organic compound with a boiling point of 100° C or greater and with intramolecular carbon-carbon double bonds; and
   c) 0.01 to 15 weight % of photopolymerization initiator.

3. A method for forming relief patterns in accordance with claim 1 above, wherein said alkali developing solvent-free liquid type photosensitive resin composition is comprised of at least one organic compound having intramolecular carbon-carbon double bonds.

4. A method for forming relief patterns in accordance with claim 1 above, wherein the thickness of said dry film resist layer is at least one half of a distance between projections and recesses formed on the surface of said substrate.

5. A method for forming relief patterns including the steps of:
   a) applying a solvent-free liquid type photosensitive resin composition over an uneven substrate so as to form an intermediate alkali developable photosensitive layer, the solvent-free liquid type photosensitive resin composition having an acid value A and a viscosity B (cps) measured at 23° C using a Brookfield viscosity meter, such that the following Equation:
$$300A + 200 > B$$
   is satisfied;
   b) forming a laminate by applying an alkali developing dry film resist layer over said intermediate alkali developing photosensitive layer;
   c) selectively exposing said laminate with light;
   d) removing the portions of said laminate which were not exposed to light in the preceding step by means of an alkali developing solution; and
   e) subjecting said laminate to at least one of heat treatment and exposure to UV radiation.

6. A method for forming relief patterns in accordance with claim 5 above, wherein said alkali developing dry film resist layer is comprised of:

a) 30 to 70 weight % of at least one acrylic polymer having carboxyl groups;

b) 30 to 70 weight % of at least one organic compound with a boiling point of 100° C or greater and with intramolecular carbon-carbon double bonds; and

c) 0.01 to 15 weight % of photopolymerization initiator.

7. A method for forming relief patterns in accordance with claim 5 above, wherein said alkali developing solvent-free liquid type photosensitive resin composition is comprised of at least one organic compound having intramolecular carbon-carbon double bonds.

8. A method for forming relief patterns in accordance with claim 5 above, wherein the thickness of said dry film resist layer is at least one half of a distance between projections and recesses formed on the surface of said substrate.

**European Patent Office**

## EUROPEAN SEARCH REPORT

Application Number

EP 91 40 2086

### DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | PATENT ABSTRACTS OF JAPAN<br>vol. 10, no. 254 (P-492)(2310) 30 August 1986<br>& JP-A-61 080 236 ( TOSHIBA CORP ) 23 April 1986<br>* abstract * | 1-8 | G03F7/095<br>G03F7/16 |
| Y | US-A-4 544 622 (W.L.KAUSCH)<br>* abstract *<br>* column 4, line 26 - column 5, line 56 * | 1-8 | |
| Y | EP-A-0 260 590 (E.I.DU PONT DE NEMOURS AND CO.)<br>* claim 1 * | 1-8 | |
| D | & JP-A-63 074 051 (...) | | |
| A | US-A-4 557 996 (T.AOYAMA ET AL)<br>* abstract * | 1 | |
| A | EP-A-0 025 088 (E.I.DU PONT DE NEMOURS AND CO.)<br>* page 1, line 24 - page 8, line 27 * | 1 | |
| | ----- | | TECHNICAL FIELDS SEARCHED (Int. Cl.5)<br><br>G03F |

The present search report has been drawn up for all claims

| Place of search | Date of completion of the search | Examiner |
|---|---|---|
| THE HAGUE | 12 NOVEMBER 1991 | MARKHAM R. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)